# EUROPEAN PATENT APPLICATION

(11) **EP 4 750 275 A2**
(43) Date of publication of application: **27.05.2026**
(21) Application number: 26172257.3
(22) Date of filing: 17.10.2023
(51) Int. Cl.: H10F 77/20

(54) **AN ELECTRODE STRUCTURE OF A BACK-CONTACT SOLAR CELL, A CELL AND ITS ASSEMBLY AND PHOTOVOLTAIC SYSTEM**

(30) Priority: 05.01.2023 CN 202310010016
(62) Divisional of application: 23203939.6
(71) Applicant: Solarlab Aiko Europe GmbH, 79110 Freiburg (DE)
(72) Inventor: CHEN, Gang, Foshan (CN); WANG, Yongqian, Foshan (CN); YANG, Xinqiang, Foshan (CN)
(74) Representative: Cohausz & Florack

(57) **Abstract**

The present application applies to the field of solar cell technology and provides an electrode structure of a back-contact solar cell, a cell and its assembly and photovoltaic system; a plurality of the first secondary gate electrodes of the electrode structure include a first collection gate electrode and a first connection gate electrode; the first collection gate electrode is connected to the first primary gate electrode and disconnected at the second primary gate electrode, the first connection gate electrode running through the second primary gate electrode between two adjacent first primary gate electrodes connects the two adjacent first primary gate electrodes, that is, the first connection gate electrode running through the second primary gate electrode connects the adjacent first primary gate electrodes, so that all first primary gate electrodes are connected in parallel as an integral whole with a more uniform electrical performance. The welded back-contact solar cell can become an integral whole with uniform electrical performance and, when the assembly is EL tested, improve the blackened
EL strip and block in the back-contact solar cell, effectively avoid the mismatch and increase the power of the assembly.

## Description

### Technical Field

The present application relates to the field of solar cell technology, in particular to an electrode structure of a back-contact solar cell, a cell and its assembly and photovoltaic system.

### Background Art

A back-contact solar cell is a type of cell with both the emitter and base contact electrodes disposed on its back (non light-receiving face), while its light-receiving face is not obstructed by any metal electrodes, effectively increasing the short-circuit current of the cell.

In related technologies, in the design of the back electrode pattern of back-contact solar cells, a thin gate is usually used to connect the primary gates of the same polarity and disconnect them at the opposite primary gate, for example, the positive fine gates are disconnected at the negative primary gate electrodes, while the negative fine gates are disconnected at the positive primary gate electrodes. In such a design, however, due to the disconnection of the fine gates at the negative primary gate electrodes, the entire cell area of the back-contact solar cell is divided into almost unrelated independent cell areas, resulting in uneven black bars and blocks in the EL test of the final product assembly, as well as reduced assembly power because of mismatch.

### Summary of the Invention

The present application provides an electrode structure of a back-contact solar cell, a cell and its assembly and photovoltaic system, aims to address the technical problem of reduced assembly power due to mismatch, caused by uneven black strip and block on the cells during the EL test of existing finished assembly of back-contact solar cells.

The present application is implemented in such a way that the electrode structure of the back-contact solar cell in the present embodiment is used for the back-contact solar cell, and the back-contact solar cell comprises the first polar region and the second polar region which are alternatively arranged, and the electrode structure includes:
a plurality of first secondary gate electrodes and a plurality of second secondary gate electrodes, which are alternately spaced, wherein the first secondary gate electrode is used to collect the current in the first polar region, and the second secondary gate electrode is used to collect the current in the second polar region; and
a plurality of first primary gate electrodes and a plurality of second primary gate electrodes, which are alternately spaced, wherein the first primary gate electrode is connected to the first secondary gate electrode and the second primary gate electrode is used to the second secondary gate electrode, the first and the second primary gate electrode are arranged in a direction different from the first and the second secondary gate electrodes;
a plurality of first secondary gate electrodes include a first collection gate electrode and a first connection gate electrode, the first collection gate electrode is connected to the first primary gate electrode and disconnected at the second primary gate electrode; the first connection gate electrode running through the second primary gate electrode between two adjacent first primary gate electrodes connects the two adjacent first primary gate electrodes, so that all the first primary gate electrodes are connected in parallel as an integral whole;

In further, a plurality of first connection gate electrodes are provided, and the first connection gate electrodes are spaced on the back-contact solar cell along the arrangement direction of the first and the second secondary gate electrodes.

In further, the width of the first connection gate electrode is 80um-1.5mm; and/or
the width of the first connection gate electrode is at least 1.5 times that of the first connection gate electrode.

In further, a plurality of first solder joints are spaced on the second primary gate electrode, and the position where the first connection gate electrode runs through the second primary gate electrode is located between two adjacent first solder joints.

In further, the distance between the first connection gate electrode and the centerline between the two adjacent first solder joints is less than or equal to 10mm.

In further, the distance between the first connection gate electrode and the centerline between the two adjacent first solder joints is less than or equal to 5mm.

In further, the distance between the first connection gate electrode and the centerline between the two adjacent first solder joints is less than or equal to 3mm.

In further, the distance between the first connection gate electrode and the centerline between the two adjacent first solder joints is less than or equal to 1mm.

In further, the position where the first connection gate electrode runs through the second primary gate electrode is covered with a first insulation layer.

In further, a plurality of second secondary gate electrodes include a second collection gate electrode and a second connection gate electrode, the second collection gate electrode is connected to the second primary gate electrode and disconnected at the first primary gate electrode, and the second connection gate electrode running through the first primary gate electrode between two adjacent second primary gate electrodes connects the two adjacent second primary gate electrodes.

In further, a plurality of second connection gate electrodes are provided, and the second connection gate electrodes are spaced on the back-contact solar cell along the arrangement direction of the first and the second secondary gate electrodes.

In further, the second connection gate electrodes are spaced adjacent to the first connection gate electrodes.

In further, the second connection gate electrode and the first connection gate electrode evenly divide the back-contact solar cell into a plurality of identical areas in the arrangement direction of the first and the second secondary gate electrodes.

In further, the width of the first connection gate electrode is 80um-1.5mm; and/or
the width of the first connection gate electrode is at least 1.5 times that of the first connection gate electrode.

In further, a plurality of second solder joints are spaced on the first primary gate electrode, and the position where the second connection gate electrode runs through the first primary gate electrode is located between two adjacent second solder joints.

In further, the distance between the second connection gate electrode and the centerline between the two adjacent second solder joints is less than or equal to 10mm.

In further, the distance between the second connection gate electrode and the centerline between the two adjacent second solder joints is less than or equal to 5mm.

In further, the distance between the second connection gate electrode and the centerline between the two adjacent second solder joints is less than or equal to 3mm.

In further, the distance between the second connection gate electrode and the centerline between the two adjacent second solder joints is less than or equal to 1mm.

In further, the position where the second connection gate electrode runs through the first primary gate electrode is covered with a second insulation layer.

The present application also provides a back-contact solar cell, including an electrode structure of the back-contact solar cell in any one of above, and the electrode structure is disposed on the shady face of the back-contact solar cell.

The present application also provides a back-contact cell assembly, which includes the aforementioned back-contact solar cell.

The present application also provides a photovoltaic system, which includes the back-contact cell assembly mentioned above.

In the electrode structure of a back-contact solar cell, a cell and its assembly and photovoltaic system presented in the embodiment of the present application, the first collection gate electrode is disconnected at the second primary gate electrode, and runs through the second primary gate electrode between two adjacent first primary gate electrodes to connect the two adjacent first primary gate electrodes, that is, a first spacing area is formed on the second primary gate electrode, and the first connection gate electrode passes through the first spacing area to connect two adjacent first primary gate electrodes. In this way, the first connection gate electrode allows to divide the back-contact solar cell into a plurality of areas in the arrangement direction of the first and the second gate electrodes, the first connection gate electrode running through the second primary gate electrode connects the adjacent first primary gate electrodes, so that all the first primary gate electrodes are connected in parallel as an integral whole with a more uniform electrical performance. The current density of the back-contact solar cell can be more uniform, for example, while the second primary gate electrode disconnected by the first connection gate electrode and a plurality of areas divided by the first connection gate electrode can be connected together through welding strips during the subsequent welding process of assembly formation, and finally, the welded back-contact solar cell can become an integral whole with uniform electrical performance and, when the assembly is EL tested, improve the blackened EL strip and block in the back-contact solar cell, effectively avoid the mismatch and increase the power of the assembly.

A part of the additional aspects and advantages of the present application will be provided in the following, and some will become apparent or may be learned through the practice of the application.

### Brief Description of the Drawings

FIG.1 is a schematic diagram of the module of the photovoltaic system provided in the embodiment of the present application;
FIG. 2 is a schematic diagram of the module of the back-contact cell assembly provided in the embodiment of the present application;
FIG. 3 is a structural schematic diagram of the electrode structure provided in the embodiment of the present application;
FIG. 4 is a structural schematic diagram of the electrode pattern design of a back-contact solar cell of the prior art;
FIG. 5 is another structural schematic diagram of the electrode structure provided in the embodiment of the present application;
FIG. 6 is yet another structural schematic diagram of the electrode structure provided in the embodiment of the present application;
FIG.7 is still another structural schematic diagram of the electrode structure provided in the embodiment of the present application;
FIG. 8 is an EL test diagram of a back-contact cell assembly in the prior art;
FIG. 9 is an EL test diagram of the back-contact cell assembly provided in the embodiment of the present application.

### Detailed Description of Embodiments

In order to make the object, technical schemes and advantages of the present disclosure clearer, the present disclosure will be further described in detail with reference to the accompanying drawings and embodiments. The examples of the embodiments are shown in the accompanying drawings, where the same or similar labels throughout represent the same or similar elements or the elements with the same or similar functions. The embodiments described below with reference to the accompanying drawings are exemplary, and are only intended to explain the present application and cannot be understood to limit the present application. In addition, it should be understood that the specific embodiments described here are intended for illustrating the present disclosure, but not for limiting the present disclosure.

In the description of the present application, it should be understood that, the terms "up", "down", "left", "right", "horizontal", and "vertical" indicate the orientation or position relationship based on the orientation or position relationship shown in the attached drawings, only for the convenience of simple description of the present application, rather than indicating or implying that the devices or elements referred to must have a specific orientation, be constructed and operated in a specific orientation, and therefore cannot be understood as a limitation on the present application.

In addition, the terms like "first" and "second" are only for illustrative purposes and cannot be understood as indicating or implying relative importance or the number of technical features referred to. Therefore, the features defined with "first" and "second" may explicitly or implicitly include at least one or a plurality of features. In the description of the present application, the meanings of "a plurality of", "pieces of", and "a number of" refer to two or more, unless otherwise specified.

The following disclosure provides many different embodiments, or examples, to implement different features in the present application. The components and arrangements of specific examples are described below to simplify the disclosure of the present application. These are, of course, merely examples and are not intended to limit the present application. In addition, the present application may repeat reference numerals and/or letters in the various examples. This repetition is for the purpose of simplicity and clarity and does not in itself dictate a relationship between the various embodiments and/or configurations discussed. In further, the application provides examples of various specific processes and materials, but person of ordinary skill in the art can be aware of the application of other processes and/or the usage scenarios of other materials.

In the present application, the first connection gate electrode allows to divide the back-contact solar cell into a plurality of areas in the arrangement direction of the first and the second gate electrodes, the first connection gate electrode running through the second primary gate electrode connects the adjacent first primary gate electrodes, so that all the first primary gate electrodes are connected in parallel as an integral whole with a more uniform electrical performance. The current density of the back-contact solar cell can be more uniform, for example, while the second primary gate electrode disconnected by the first connection gate electrode, and a plurality of areas divided by the first connection gate electrode, can be connected together through welding strips during the subsequent welding process of assembly formation, and finally, the welded back-contact solar cell can become an integral whole with uniform electrical performance and, when the assembly is EL tested, improve the blackened EL strip and block in the back-contact solar cell, effectively avoid the mismatch and increase the power of the assembly.

### Embodiment 1

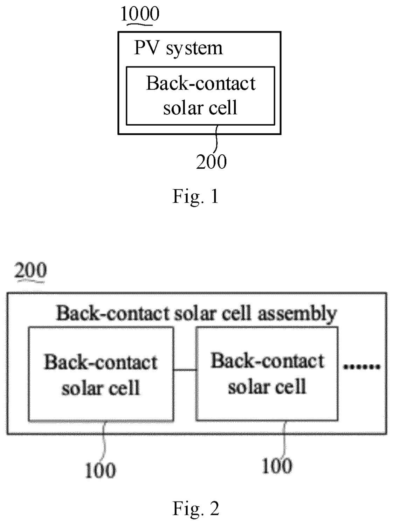

Referring to FIG. 1 to 2, the photovoltaic system 1000 in the embodiment of present application may include the back-contact cell assembly 200 that includes a plurality of back-contact solar cells 100 in the embodiment of present application. A plurality of back-contact solar cells 100 in the back-contact cell assembly 200 can be sequentially connected in series to form a plurality of cell strings. Each cell string can be connected in series, in parallel, or in combination to achieve current convergence output. The connection between each cell can be achieved, for example, by welding strips, and the connection between each cell string can be achieved through the busbar. In the present application, for example, when forming the assembly, the first primary gate electrode 13 and the second primary gate electrode 14 can both be welded with welding strips to achieve the connection between the back-contact solar cells 100, thereby forming a back-contact cell assembly 200.

The back-contact solar cell 100 in the embodiment of the present application can include a substrate (not shown in the figure) and an electrode structure 10 in the embodiment of the present application. The substrate can be a silicon wafer, and the back of the substrate (i.e. the shady face of the back-contact solar cell 100) is alternatively provided with first and second polar regions (not shown in the figure) having mutually opposite polarities. The first polar region and the second polar region, for example, can be a P-type doping region and an N-type doping region, respectively; for another instance, the first polar region and the second polar region can be an N-type doping region and a P-type doping region, respectively, which are not limited here.

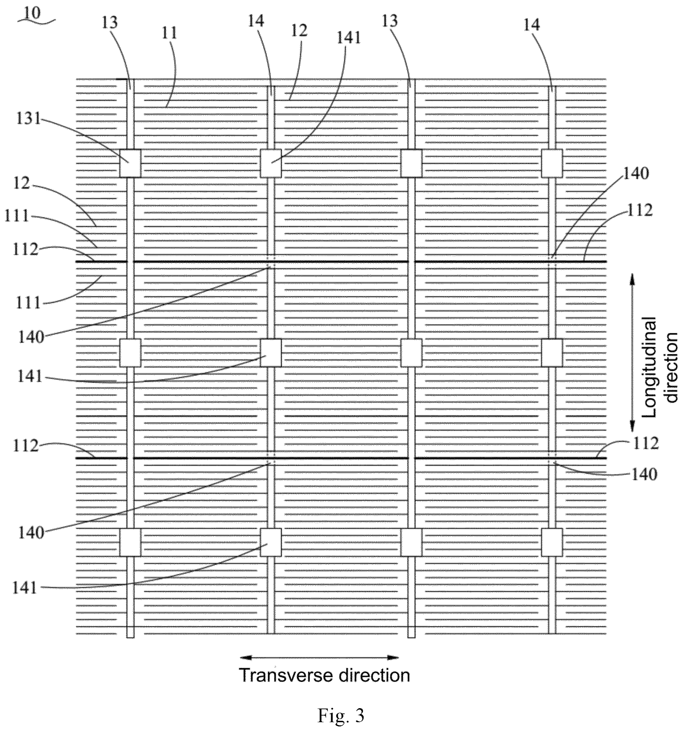

Referring to FIG. 3, the electrode structure 10 in the embodiment of the present application can be disposed on the shady face of the back-contact solar cell 100, and the electrode structure 10 can include a plurality of the first gate electrodes 11 and a plurality of the second gate electrodes 12, which are alternately spaced, as well as a plurality of the first gate electrodes 13 and a plurality of the second gate electrodes 14, which are alternately spaced.

The first secondary gate electrode 11 and the second secondary gate electrode 12 are respectively used to collect the current in the first polar region and second polar region, that is, the first secondary gate electrode 11 and the second secondary gate electrode 12 can correspond to the first polar region and second polar region, respectively.

The first primary gate electrode 13 and the second primary gate electrode 14 are arranged in a direction different from that of the first secondary gate electrode 11 and the second secondary gate electrode 12. As shown in FIG. 3, for example, the first secondary gate electrode 11 and the second secondary gate electrode 12 are alternately arranged in a transverse direction, while the first primary gate electrode 13 and the second primary gate electrode 14 are alternately arranged in a longitudinal direction, forming a mutually perpendicular arrangement. The first primary gate electrode 13 is connected to the first secondary gate electrode 11, and the second primary gate electrode 14 is connected to the second secondary gate electrode 12, that is, the first primary gate electrode 13 can be used to accumulate the current collected by the first secondary gate electrode 11, and the second primary gate electrode 14 can be used to accumulate the current collected by the second secondary gate electrode 12.

A plurality of the first secondary gate electrodes 11 can include a first collection gate electrode 111 and a first connection gate electrode 112 (the bold gate electrode in FIG. 3); the first collection gate electrode 111 is connected to the first primary gate electrode 13 and disconnected at the second primary gate electrode 14, the first connection gate electrode 112 running through the second primary gate electrode 14 between two adjacent first primary gate electrodes 13 connects the two adjacent first primary gate electrodes 13, that is, as shown in FIG. 3, a first spacing area 140 can be formed on the second primary gate electrode 14, and the first connection gate electrode 112 passes through the first spacing area 140 to connect two adjacent first primary gate electrodes 13.

It is understood that in this way the first connection gate electrode 112 is insulated and isolated from the second primary gate electrode 14 through the first spacing area 140.

In the electrode structure 10, back-contact solar cell 100, back-contact solar cell assembly 200 and photovoltaic system 1000 presented in the embodiment of the present application, the first collection gate electrode 111 is disconnected at the second primary gate electrode 14, and the first connection gate electrode 112 running through the second primary gate electrode 14 between two adjacent first primary gate electrodes 13 connects the two adjacent first primary gate electrodes 13, that is, a first spacing area 140 is formed on the second primary gate electrode 14, and the first connection gate electrode 112 passes through the first spacing area 140 to connect two adjacent first primary gate electrodes 13. In this way, the first connection gate electrode 112 allows to divide the back-contact solar cell 100 into a plurality of areas in the arrangement direction (i.e. the longitudinal direction in the figure) of the first gate electrodes 11 and the second gate electrodes 12, the first connection gate electrode 112 running through the second primary gate electrode 14 connects the adjacent first primary gate electrodes 13, so that all the first primary gate electrodes 13 are connected in parallel as an integral whole with a more uniform electrical performance. The current density of the back-contact solar cell 100 can be more uniform, for example, while the second primary gate electrode 14 disconnected by the first connection gate electrode 112, and a plurality of areas divided by the first connection gate electrode 112, can be connected together through welding strips during the subsequent welding process of assembly formation, and finally, the welded back-contact solar cell 100 can become an integral whole with uniform electrical performance and, when the assembly is EL tested, improve the blackened EL strip and block in the back-contact solar cell 100, effectively avoid the mismatch and increase the power of the assembly.

In the field of solar cell technology, it can be understood that EL testing, also known as electroluminescence testing, is usually conducted to detect internal defects in solar cells. In EL testing, the brightness of a test image is directly proportional to the minority carrier lifetime (or minority carrier diffusion length) and current density of solar cell. The shorter minority carrier diffusion length in the areas with defects in the solar cell results in a darker image brightness. Typically the defects relate to the silicon material, diffusion, printing, sintering, and to the abnormal single cells with different conversion efficiency.

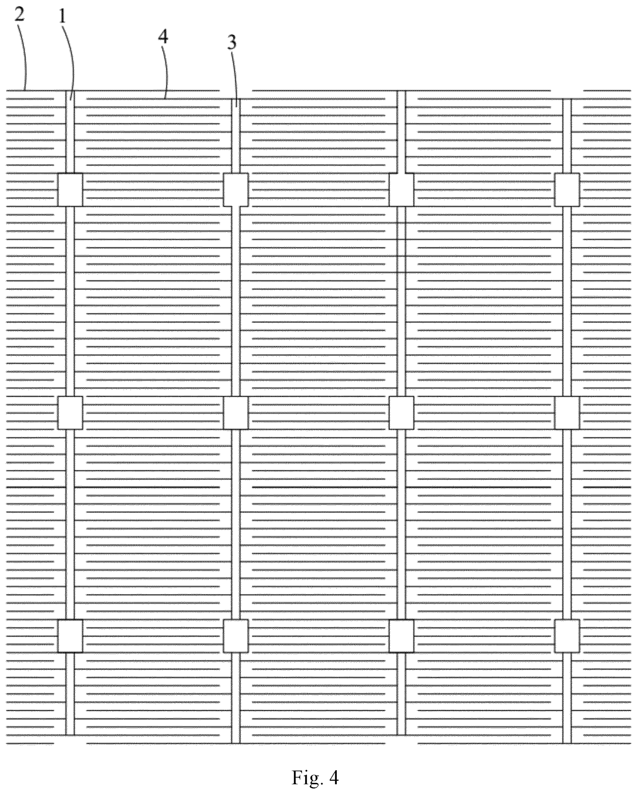

Referring to FIG. 4, it is easy to understand that in prior art, the secondary gate electrodes of different polarities are connected to the primary gate electrodes of the same polarities and disconnected at the opposite primary gate electrodes. As shown in FIG. 4, the positive secondary gate 2 is connected to the positive primary gate 1 and disconnected at the negative primary gate 3, while the negative secondary gate 4 is connected to the negative primary gate 3 and disconnected at the positive primary gate 1. In this case, there is an almost unrelated independent cell area between each two identical primary gate electrodes, while back-contact solar cells may have some defects, and the defects in the silicon material itself may cause uneven black stripes or blocks on the test image during subsequent EL testing, for example, the image of stripes with different light and shade will cause a certain mismatch and reduced power to the subsequently formed assembly.

Compared to the electrode design scheme in the prior art shown in FIG. 4, however, in the embodiment of the present application, the first connection gate electrode 112 in the first secondary gate electrode 11 running through the second primary gate electrode 14 connects the adjacent first primary gate electrode 13, so that the first primary gate electrodes 13 of the same polarity can be connected in parallel as an integral whole, with uniform electrical performance (such as uniform current density) and with improved blackening strip and block shapes in EL images, and each back-contact solar cell 100 in the EL image has more uniform brightness, thereby increasing the power of the back-contact cell assembly 200.

Specifically, in the embodiment of the present application, the first and second polar regions have opposite polarities, so do the first and second secondary gate electrodes 11 & 12. For example, the first secondary gate electrode 11, a positive secondary gate electrode, is used to collect positive current in the positive electrode area, while the second secondary gate electrode 12, a negative secondary gate electrode, is used to collect negative current in the negative electrode area; alternatively, the first secondary gate electrode 11, a negative secondary gate electrode, is used to collect negative current in the negative electrode area, and the second secondary gate electrode 12, a positive gate electrode, is used to collect positive current in the positive electrode area. The positive secondary gate electrode and the negative secondary gate electrode are respectively disposed in the P-type doping region and N-type doping region of the back-contact solar cell 100.

As shown in FIG. 3, in the embodiment shown in FIG. 3, the first and second primary gate electrodes 11 & 12 are alternatively arranged in the longitudinal direction, and correspondingly, so do the first and second polar regions. The first primary gate electrode 13 and the second primary gate electrode 14 can be alternatively arranged with the first secondary gate electrode 11 and the second secondary gate electrode 12 in the transverse direction, that is, in the embodiment shown in FIG. 3, the first connection gate electrode 112 can, along the longitudinal direction, divide the entire back-contact solar cell 100 into a plurality of areas which can be connected through welding strips during the process of welding assembly, and finally, making the welded back-contact solar cell 100 as a whole with uniform electrical performance.

In addition, it can be understood that in the embodiment of the present application, the number of the first and the second gate electrodes 11 & 12 can be determined based on the actual area size of the back-contact solar cell 100, the width of and the distance between the first and the second gate electrodes 11 & 12, which are subject to no specific restrictions here.

In further, in the embodiment of the present application, the first and the second gate electrodes 11 & 12 may be aluminum gate wires, silver gate wires, copper gate wires, or silver plated copper gate wires, which are subject to no restrictions here.

It can be understood that in the embodiment of the present application, the first and the second gate electrodes 11 & 12 can be gate wires of the same or different metals, for example, aluminum gate wires are selected for both the the first gate electrodes 11 and a plurality of the second gate electrodes 12; alternatively, aluminum gate wires and silver gate wires are selected for the first gate electrode 11 and the second gate electrode 12, respectively. If the first or second gate electrodes 11 or 12 are aluminum or silver gate wires, aluminum or silver gate wires can be printed onto the doping area of the back-contact solar cell 100 through screen printing; if the first or second gate electrodes 11 or 12 are copper gate wires, copper gate wires can be plated on the doping area of the back-contact solar cell 100 through electroplating or evaporation.

In the embodiment of the present application, of course, gate wires such as copper, silver, aluminum, or silver coated copper, can also be used for the first primary gate electrode 13 and the second primary gate electrode 14, which are not subject to restrictions here.

It can be understood that in the embodiment of the present application, the back-contact cell assembly 200 may also include a metal frame, a backplate, photovoltaic glass, and an adhesive film (not shown in the figure). The adhesive film can serve as a fill between the front of the back-contact solar cell 100 and the photovoltaic glass, the back and the backplate, as well as adjacent cells. The filler can be a transparent colloid with good transparency and aging resistance. The adhesive film, for example, can be EVA or POE film, and can be selected according to the actual situation, which are not subject to restrictions here.

Photovoltaic glass that covers the adhesive film on the front of the back-contact solar cell 100 can be the ultra white glass having high transmittance and transparency, and excellent physical, mechanical, and optical properties. Ultra white glass, for example, has a transmittance of over 92% and can, as far as possible, protect the back-contact solar cell 100 without affecting its efficiency. Meanwhile, the adhesive film can bond the photovoltaic glass and the back-contact solar cell 100 together, and the use of adhesive film can seal and insulate the back-contact solar cell 100 against water and moisture.

The backplate, which is attached to the adhesive film on the back of the back-contact solar cell 100, can protect and support the back-contact solar cell 100, and have reliable insulation, and water and aging resistance. a plurality of backplates, usually tempered glass, organic glass, aluminum alloy TPT composite adhesive film, etc., can be selected specifically according to the specific situation, which are not subject to restrictions here. The overall structure composed of the backplate, back-contact solar cell 100, adhesive film, and photovoltaic glass can be disposed on a metal frame, and the metal frame serves as the main external support structure for the entire back-contact cell assembly 200 and provides stable support and installation for the back-contact cell assembly 200. The back-contact cell assembly 200, for example, can be installed in the desired position through the metal frame.

In further, in this embodiment, photovoltaic system 1000 can be applied to photovoltaic power plants, such as ground power plants, rooftop power plants, surface power plants, etc., as well as to the equipment or devices that utilize solar energy for power generation, like users' solar power sources, solar street lights, solar cars, solar buildings, etc. It can be understood that, of course, the application scenarios of photovoltaic system 1000 are not limited to these, that is, photovoltaic system 1000 can be further applied in all fields that realize power generation based on solar energy. Taking photovoltaic power generation system network as an example, photovoltaic system 1000 can include photovoltaic system, combiner box and inverter. photovoltaic system can be an array combination of a plurality of back-contact cell assembly 200. A plurality of photovoltaic systems, for example, can be formed by a plurality of back-contact cell assemblies 200. photovoltaic system is connected to combiner box which can converge the current generated by photovoltaic system, and the converged current, after flowing through the inverter and being converted into AC power required by the municipal power grid, is then connected to the municipal power grid to provide solar power.

### Embodiment 2

Referring to FIG. 3, in some embodiments, a plurality of first connection gate electrodes 112 are provided, and the first connection gate electrodes 112 are spaced on the back-contact solar cell 100 along the arrangement direction (i.e. the longitudinal direction in FIG.3) of the first gate secondary gate electrodes 11 and the second secondary gate electrodes 12.

In this way, a plurality of the first connection gate line electrodes 112 ensure the back-contact solar cell 100 with a more uniform electrical performance, and a plurality of first connection gate line electrodes 112 are divided into a plurality of areas that can be connected together through welding strips in the subsequent welding process, forming an integral whole with uniform electrical performance.

Specifically, as shown in FIG. 3, in such an embodiment, the first connection gate electrodes 112, preferably, are uniformly spaced along the longitudinal direction, and a plurality of first connection gate electrodes 112 can help achieve the uniform electrical performance (such as current density), improve the brightness in the EL test image, provide a back-contact solar cell 100 with more uniform brightness, and improve the blackened EL strip and block. In the present application, the number of the first connection gate line electrodes 112 can be determined based on the size of the back-contact solar cell 100, and the spacing between adjacent first connection gate line electrodes 112 can also be set according to specific circumstances, which are subject to no restrictions here.

In addition, it should be noted that FIG. 3 only presents two first connection gate electrodes 112, and some of the secondary and primary gate electrodes of the electrode structure 10 as examples. It can be understood that in some embodiments, the first secondary gate electrodes 11 and the second secondary gate electrodes 12 can also be provided in the upper, lower, left, and right side in FIG. 3, a plurality of first primary gate electrodes 13 and second primary gate electrodes 14 can also be provided in the left and right directions, and a plurality of first connection gate electrodes 112 can also be arranged above and below the first connection gate electrode 112. The specific number of these electrodes can be determined based on the size of the back-contact solar cell 100, which are subject to no restrictions here.

### Embodiment 3

In some embodiments, the width of the first connection gate electrode 112 can be 80um-1.5mm.

In this way, the first connection gate electrodes 112 having a rational width within the reasonable range of 80um-1.5mm can ensure that the first connection gate electrodes 112 are connected in parallel to two adjacent first primary gate electrodes 13 for current collection and uniform electrical performance, and prevent the first connection gate electrodes 112 from overheating or even melting since the first connection gate electrodes 112 with too small width fail to withstand the current transmission between two adjacent first primary gate electrodes 13, and also avoid the waste of paste as a result of the too large width of the first connection gate electrodes 112.

Specifically, in such embodiments, the width of the first connection gate electrode 112 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the first connection gate electrode 112 may be preferably greater than 1.5 times that of the first collection gate electrode 111.

In this way, the first connection gate electrode 112 with a width greater than 1.5 times that of the first collection gate electrode 111 can ensure a more uniform current density and reliability.

It can be understood that, of course, if performance permits, the width of the first connection gate electrode 112 can also be basically the same as that of the first collection gate electrode 111, in order to reduce the use of paste. In this case, a plurality of first connection gate electrodes 112 can be used to realize parallel connection with the first primary gate electrodes 13.

### Embodiment 4

Referring to FIG. 3, in some embodiments, a plurality of first solder joints 141 are spaced on the second primary gate electrode 14, the position where the first connection gate electrode 112 runs through the second primary gate electrode 14 is located between two adjacent first solder joints 141, that is, the first spacing area 140 is located between two adjacent first solder joints 141.

The deployment of a first connection gate electrode 112 between two adjacent first solder joints 141 can ensure the integrity of the first welding point 141 and the welding performance of the second solder joint 141 while providing parallel connection between the two adjacent first primary gate electrodes 13.

Specifically, in such embodiments, a plurality of first solder joints 141 can be evenly spaced on the second primary gate electrode 14, and preferably, a first connection gate electrode 112 is disposed between two adjacent first solder joints 141. In this way, the arrangement of a first connection gate electrode 112 between each two first solder joints 141 can reduce the number of first spacing areas 140 between the two adjacent first solder joints 141, and avoid affecting the welding of the second primary gate electrode 14.

In such an embodiment, the distance between two adjacent first solder joints 141 on the second primary gate electrode 14 can be greater than 5mm, preferably greater than 9mm. In some embodiments, in order to reduce the use of paste at the first solder joint 141 of the same size, the distance between two adjacent first solder joints 141 can be greater than 11mm but less than or equal to 45mm.

In further, in such embodiments, the spacing between two adjacent first solder joints 141 may be preferably greater than 11mm but less than or equal to 30mm. The first solder joints 141 having a spacing within this optimal range can ensure the number of first solder joints 141 to provide welding reliability without poor welding, and also avoid an increasing costs due to the excessive number of first solder joints 141.

In some embodiments, of course, the position where the first connection gate electrode 112 runs through the second primary gate electrode 14 can also be located on the first solder joint 141, that is, a first spacing area 140 is formed on the first solder joint 141 to allow the first connection gate electrode 112 to pass through.

Each first solder joint 141 corresponds to a first connection gate electrode 112, and the first connection gate electrodes 112 are uniformly arranged to ensure the connection reliability.

Specifically, in such a case, the first solder joint 141 can be divided into two relatively spaced parts by the first connection gate electrode which can preferably be located at the center of the first solder joint 141. The first connection gate electrode 112, which passes through the center of the first solder joint 141, connects the two adjacent first primary gate electrodes 13 to realize parallel connection.

In such cases, in order to avoid the first solder joint 141 being separated by the first connection gate electrode and affecting the subsequent welding effect, a larger length or width can be set for the first solder joint 141, thereby ensuring the reliability of subsequent welding.

### Embodiment 5

In further, referring to FIG. 3, in some embodiments, the distance between the first connection gate electrode 112 and the centerline between the two adjacent first solder joints 141 is less than or equal to 10mm, that is, the distance between the first connection gate electrode 112 and the midpoint between two adjacent first solder joints 141 is less than or equal to 10mm.

A suitable distance between the first connection gate electrode 112 and the first solder joint 141 avoids the false soldering during welding caused by the first connection gate electrode 112, also provides a more uniform electrical performance (such as current density).

It can be understood that, in some embodiments, during printing process, the height of the first connection gate electrode 112 is the same as or even slightly higher than that of the first solder joint 141. The distance between the first connection gate electrode 112 and the first solder joint 141 cannot be too small, otherwise the certain height difference between them may lead to false soldering during welding. Therefore, a distance less than or equal to 10mm between the first connection gate electrode 112 and the centerline of two adjacent first solder joints 141 can effectively avoid the occurrence of false soldering and increased defect rate due to the small distance between them.

In further, in such an embodiment, the distance between the first connection gate electrode 112 and the centerline between the two adjacent first solder joints 141 is less than or equal to 5mm.

In this way, the distance between the first connection gate electrode 112 and the center of two first solder joints 141, which falls within the preferred range, can improve the subsequent welding performance and ensure a more uniform electrical performance.

In such an embodiment, the distance between the first connection gate electrode 112 and the centerline between two adjacent first solder joints 141 can be preferably less than or equal to 3mm, most preferably 1mm, so that the first connection gate electrode 112 can overlap with the centerline between the two first solder joints 141 as much as possible to improve the uniformity of electrical performance.

### Embodiment 6

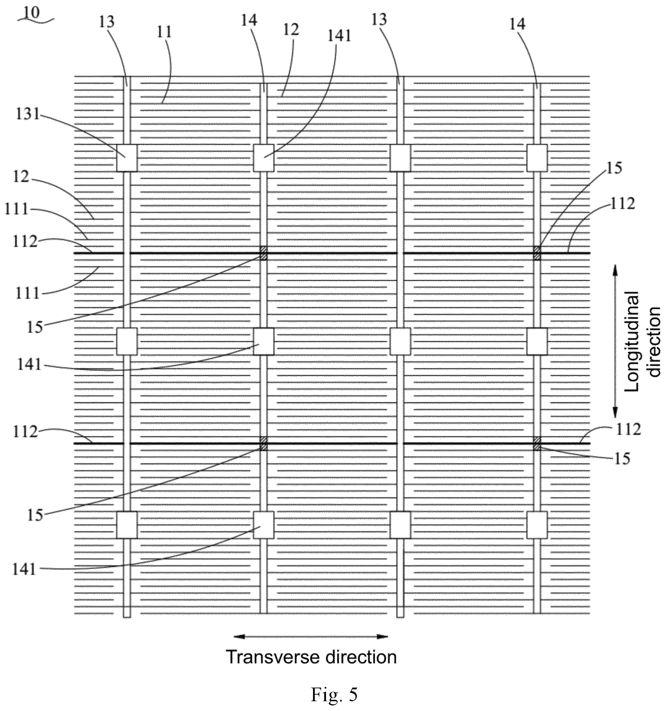

Referring to FIG.5, in some embodiments, the position where the first connection gate electrode 112 runs through the second primary gate electrode 14 is covered with a first insulation layer 15, that is, the first spacing area 140 in FIG. 3 can be covered with a first insulation layer 15.

The area of the second primary gate electrode 14 where the first connection gate electrode 112 runs through is covered by the first insulation layer 15, thus avoiding electric leakage caused by the contact between the welding strip and the first connection gate electrode 112 when welding the first solder joint 141.

Specifically, for the purpose of insulation, the size of the first insulation layer 15 can be equal to or slightly larger than that of the first spacing area 140 on the second primary gate electrode 14, that is, only the area on the second primary gate electrode 14 corresponding to the first spacing area 140 is covered with the first insulation layer 15, and in other areas no first insulation layer 15 is provided. The first insulation layer 15 can be an insulating adhesive.

### Embodiment 7

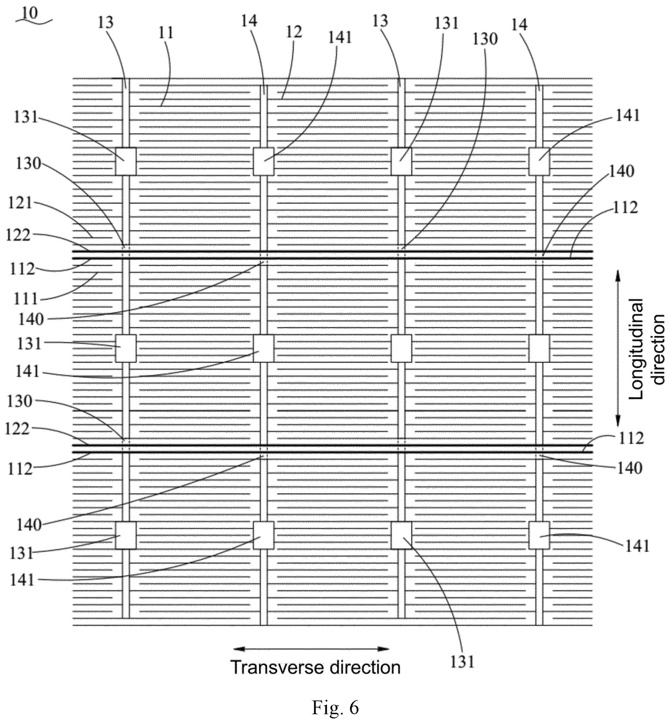

Referring to FIG. 6, in some embodiments, a plurality of second gate electrodes 12 may include a second collection gate electrode 121 and a second connection gate electrode 122; the second collection gate electrode 121 is connected to the second primary gate electrode 14 and disconnected at the first primary gate electrode 13, the second connection gate electrode 122 running through the first primary gate electrode 13 between two adjacent second primary gate electrodes 14 connects the two adjacent second primary gate electrodes 14, that is, as shown in FIG. 6, a second spacing area 130 is formed on the first primary gate electrode 13, and the second connection gate electrode 122 passes through the second spacing area 130 to connect two adjacent second primary gate electrodes 14.

It is understood that in this way the second connection gate electrode 122 is insulated and isolated from the first primary gate electrode 13 through the second spacing area 130.

The first connection gate electrode 112 and the second connection gate electrode 122 allows to divide the back-contact solar cell 100 into a plurality of areas in the arrangement direction of the first gate electrodes 11 and the second gate electrodes 12 (i.e. the longitudinal direction in FIG. 6), the first connection gate electrode 112 running through the second primary gate electrode 14 connects adjacent first primary gate electrodes 13 together, so that all first primary gate electrodes 13 are connected in parallel as an integral whole, the second connection gate electrode 122 running through the first primary gate electrode 13 connects all adjacent second primary gate electrodes 14 together in parallel as an integral whole. A plurality of areas divided by the first connection gate electrode 112 and the second connection gate electrode 122 can be connected together through welding strips during the subsequent welding process of assembly formation, providing the back-contact solar cell further with a more uniform electrical performance (such as current density) and, when the cell assembly is EL tested, improve the blackened EL strip and block in the back-contact solar cell and increase assembly power.

In such an embodiment, namely, the use of the second connection gate electrode 122 can further improve the uniformity of electrical performance of the back-contact solar cell 100, further improve the uneven brightness in the EL test image, and provide the back-contact solar cell 100 in the EL test image with a more uniform brightness, thereby further increasing the power of the assembly.

### Embodiment 8

Referring to FIG. 6, similar to the first connection gate electrode 112, in some embodiments, a plurality of second connection gate electrodes are provided 122, and the second connection gate electrodes 122 are spaced on the back-contact solar cell along the arrangement direction of the first gate secondary gate electrodes 11 and the second secondary gate electrodes 12.

In this way, a plurality of the second connection gate line electrodes 122 ensure the back-contact solar cell 100 with a more uniform electrical performance, and a plurality of second connection gate line electrodes 122 are divided into a plurality of areas that can be connected together through welding strips in the subsequent welding process, forming an integral whole with uniform electrical performance.

Specifically, as shown in FIG. 3, in such an embodiment, the second connection gate electrodes 122, preferably, are uniformly spaced along the longitudinal direction, and a plurality of second connection gate electrodes 122 can help achieve the uniform electrical performance (such as current density), improve the brightness in the EL test image, provide a back-contact solar cell 100 with more uniform brightness, and improve the blackened EL strip and block. In the present application, the number of the second connection gate line electrodes 122 can be determined based on the size of the back-contact solar cell 100, and the spacing between adjacent second connection gate line electrodes 122 can also be set according to specific circumstances, which are subject to no restrictions here.

### Embodiment 9

In some embodiments, the second connection gate electrodes 122 may preferably be spaced adjacent to the first connection gate electrodes 112.

The adjacent arrangement of the second connection gate electrodes 122 and the first connection gate electrodes 112 can ensure a smaller position difference between the first spacing area 140 on the second primary gate electrode 14 and the second spacing area 130 on the first primary gate electrode 13, in order to facilitate the fabrication of the first primary gate electrode 13 and the second primary gate electrode 14.

In further, in such an embodiment, the second connection gate electrode 122 and the first connection gate electrode 112 evenly divide the back-contact solar cell 100 into a plurality of identical areas in the arrangement direction of the first gate electrode 11 and the second gate electrode12.

In this way, the first connection gate electrode 112 and the second connection gate electrode 122 can divide the back-contact solar cell 100 into identical areas with relatively uniform electrical performance, so that the integral whole formed by connecting areas through welding has a more uniform electrical performance, further improving the power of the assembly.

Specifically, as shown in FIG. 6, the first connection gate electrode 112 and the second connection gate electrode 122 can longitudinally divide the back-contact solar cell 100 into a plurality of almost independent regions, each of which is equivalent to a small piece of solar cell, and a plurality of areas are connected together through welding strips in the subsequent assembly welding to form an integral whole with uniform electrical performance and increased power. It can be understood that since the first primary gate electrode 13 and the second primary gate electrode 14 are both separated into a plurality of segments, a plurality of segments of primary gate electrodes can be connected by subsequent welding strips.

It can be understood that, of course, in some embodiments, the first connection gate electrode 112 and the second connection gate electrode 122 may not be adjacently arranged, but separately spaced, which are subject to no restrictions here.

### Embodiment 10

In some embodiments, the width of the second connection gate electrode 122 can be 80um-1.5mm.

In this way, the second connection gate electrodes 122 having a rational width within the reasonable range of 80um-1.5mm can ensure that the second connection gate electrodes 122 are connected in parallel to two adjacent second primary gate electrodes 14 for current collection and uniform electrical performance, and prevent the second connection gate electrodes 122 from overheating or even melting since the second connection gate electrodes 122 with too small width fail to withstand the current transmission between two adjacent second primary gate electrodes 14, and also avoid the waste of paste as a result of the too large width of the second connection gate electrodes 122.

Specifically, in such embodiments, the width of the second connection gate electrode 122 can be any one of the values from 80um, 100um, 200um, 300um, 400um, 500um, 600um, 700um, 800um, 900um, 1mm, 1.1mm, 1.2mm, 1.3mm, 1.4mm, 1.5mm, or 80um-1.5mm, which are subject to no restrictions here.

In further, in some embodiments, the width of the second connection gate electrode 122 may be preferably greater than 1.5 times that of the first collection gate electrode 121.

In this way, the second connection gate electrode 122 with a width greater than 1.5 times that of the second collection gate electrode 121 can ensure a more uniform current density and reliability.

It can be understood that, of course, if performance permits, the width of the second connection gate electrode 122 can also be basically the same as that of the second collection gate electrode 121, in order to reduce the use of paste. In this case, a plurality of second connection gate electrodes 122 can be set to realize parallel connection with the second primary gate electrodes 14.

### Embodiment 11

Referring to FIG. 6, in some embodiments, a plurality of second solder joints 131 are spaced on the second primary gate electrode 14, the position where the second connection gate electrode 122 runs through the second primary gate electrode 14 is located between two adjacent second solder joints 131, that is, the second spacing area 130 is located between two adjacent second solder joints 131.

The deployment of a second connection gate electrode 122 between two adjacent second solder joints 131 can ensure the integrity of the second welding point 131 and the welding performance of the first solder joint 13 while providing parallel connection between the two adjacent second primary gate electrodes 14.

Specifically, in such embodiments, a plurality of second solder joints 131 can be evenly spaced on the first primary gate electrode 13, and preferably, a second connection gate electrode 122 is disposed between two adjacent second solder joints 131. In this way, the deployment of a second connection gate electrode 122 between each two second solder joints 131 can reduce the number of second spacing area 130 between two adjacent second solder joints 131, and avoid affecting the welding of the second primary gate electrode 14.

In such an embodiment, the distance between two adjacent second solder joints 131 on the second primary gate electrode 14 can be greater than 5mm, preferably greater than 9mm. In some embodiments, in order to reduce the use of paste at the second solder joint 121 of the same size, the distance between two adjacent second solder joints 131 can be greater than 11mm but less than or equal to 45mm.

In further, in such embodiments, the spacing between two adjacent second solder joints 131 may be preferably greater than 11mm but less than or equal to 30mm. The second solder joints 131 having a spacing within this optimal range can ensure the number of second solder joints 131 to provide welding reliability without poor welding, and also avoid an increasing costs due to the excessive number of second solder joints 131.

In some embodiments, of course, the position where the second connection gate electrode 122 runs through the first primary gate electrode 13 can also be located on the second solder joint 141, that is, a second spacing area 130 is formed on the second solder joint 131 to allow the second connection gate electrode 122 to pass through.

Each second solder joint 131 corresponds to a second connection gate electrode 122, and the second connection gate electrodes 14 are uniformly arranged to ensure the connection reliability.

Specifically, in such a case, the second solder joint 131 can be divided into two relatively spaced parts by the second connection gate electrode 122, and the second connection gate electrode 122 can preferably be located at the center of the second solder joint 131. The second connection gate electrode 122, which passes through the center of the second solder joint 141, connects the two adjacent second primary gate electrodes 13 to realize parallel connection.

In such cases, in order to avoid the second solder joint 131 being separated by the second connection gate electrode and affecting the subsequent welding effect, a larger length or width can be set for the second solder joint 131, thereby ensuring the reliability of subsequent welding.

### Embodiment 12

In further, referring to FIG. 6, in some embodiments, the distance between the second connection gate electrode 122 and the centerline between the two adjacent second solder joints 131 is less than or equal to 10mm, that is, the distance between the second connection gate electrode 122 and the midpoint between two adjacent second solder joints 131 is less than or equal to 10mm.

A suitable distance between the second connection gate electrode 122 and the second solder joint 131 avoids the false soldering during welding caused by the second connection gate electrode 122, also provides a more uniform electrical performance (such as current density).

It can be understood that, in some embodiments, during printing process, the height of the second connection gate electrode 122 is the same as or even slightly higher than that of the first solder joint 131. The distance between the second connection gate electrode 122 and the second solder joint 131 cannot be too small, otherwise the certain height difference between them may lead to false soldering during welding. Therefore, a distance less than or equal to 10mm between the second connection gate electrode 122 and the centerline of two adjacent second solder joints 131 can effectively avoid the occurrence of false soldering and increased defect rate due to the small distance between them.

In further, in some embodiments, the distance between the second connection gate electrode 122 and the centerline between the two adjacent second solder joints 131 is less than or equal to 5mm.

In this way, the distance between the second connection gate electrode 122 and the center of two second solder joints 131, which falls within the preferred range, can improve the subsequent welding performance and ensure a more uniform electrical performance.

In such an embodiment, the distance between the second connection gate electrode 122 and the centerline between two adjacent second solder joints 131 can be preferably less than or equal to 3mm, most preferably 1mm, so that the second connection gate electrode 122 can overlap with the centerline between the two second solder joints 131 as much as possible to improve the uniformity of electrical performance.

### Embodiment 13

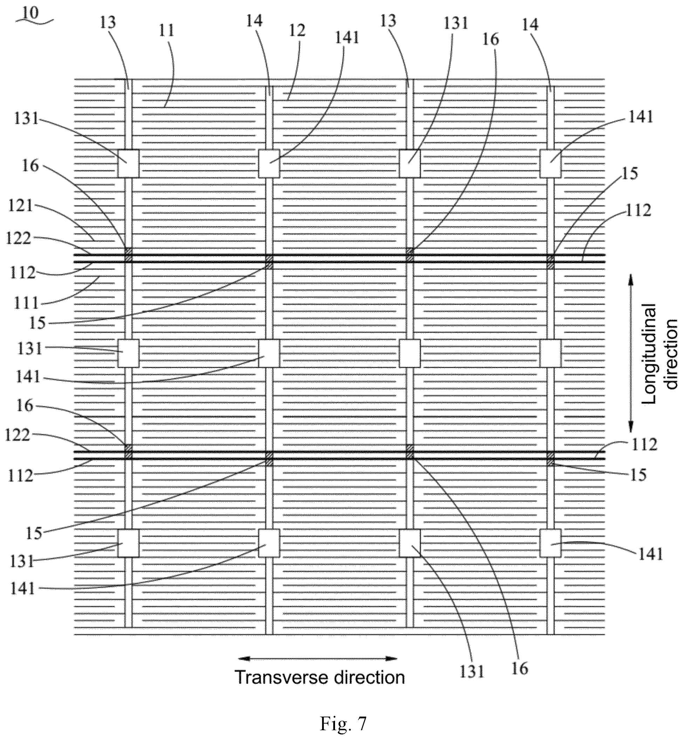

Referring to FIG.7, in some embodiments, the position where the second connection gate electrode 122 runs through the first primary gate electrode 13 is covered with a second insulation layer 16, that is, the first spacing area 130 in FIG. 6 can be covered with a second insulation layer 16.

The area of the first primary gate electrode 13 where the second connection gate electrode 112 runs through is covered by the second insulation layer 16, thus avoiding electric leakage caused by the contact between the welding strip and the second connection gate electrode 122 when welding the second solder joint 131.

Specifically, for the purpose of insulation, the size of the second insulation layer 16 can be equal to or slightly larger than that of the second spacing area 130 on the first primary gate electrode 13, that is, only the area on the first primary gate electrode 13 corresponding to the second spacing area 130 is covered with the first insulation layer 16, and in other areas no second insulation layer 16 is provided. The second insulation layer 16 can be an insulating adhesive.

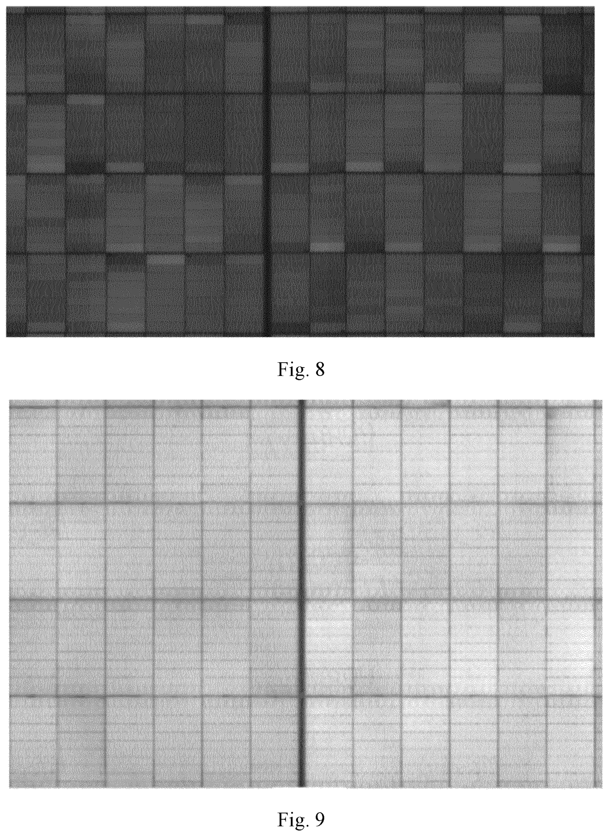

Finally, referring to FIG. 8 and 9, FIG. 8 shows the EL test images of the assembly formed by the back-contact solar cell using the electrode pattern design in Figure 4 under prior art, while FIG. 9 shows the EL test images of the assembly formed by the back-contact solar cell using the electrode structure in FIG. 6 and 7 of the present application. Each small rectangle in FIG. 8 and 9 represents a back-contact solar cell.

FIG. 8 shows that in the prior art, severe black stripes (i.e. black and white stripes with different light and shade) appear in the brightness images obtained during EL testing of assembly, leading to assembly mismatch and decreased power. In FIG. 9, after the electrode structure in the present application is used, the back-contact solar cell becomes an integral whole with uniform electrical performance. In the EL testing image, each area of the back-contact solar cell has relatively uniform brightness, and the assembly power is also correspondingly increased.

The following Table 1 presents performance test comparison between the assembly formed by the back-contact solar cell using the electrode pattern in FIG. 4 and that formed by the back-contact solar cell using the electrode structure of the present application.

**Table 1**

| | CTM (%) | Gain (%) |
|---|---|---|
| Contrasting example | 98.60 | 0.32 |
| Present application | 98.92 | |

The contrasting example 1 in Table 1 represents the assembly formed by a back-contact solar cell using the electrode pattern in FIG.4, while the present application provides an assembly formed by a back-contact solar cell using the electrode structure in FIG. 6 and 7. The CTM value represents the ratio of the power of the packaged assembly to that of the back-contact solar cell before packaging, and the gain is the difference between the CTM value of the present application and that of the contrasting example. According to Table 1, in the contrasting example, after packaging, the assembly's power is reduced to 98.60% of the back-contact solar cell, resulting in a packaging loss of 1.40%. In the present application, the power of the module is reduced to 98.92% of that of the back-contact solar cell, resulting in a packaging loss of 1.08%. Compared to the contrasting example, the assembly in the present application has the power 0.32% higher, indicating that the present application's technical solution can effectively reduce the packaging loss of assembly during packaging and improve its power.

In the description of the specification, the reference terms "some embodiments", "illustrative embodiments", "examples", "specific examples", or "some examples" refer to the specific features, structures, materials, or characteristics described in conjunction with the embodiments or examples included in at least one embodiment or example of the present application. The schematic expressions of the above terms in the specification do not necessarily refer to the same embodiments or examples. Moreover, the specific features, structures, materials, or characteristics described can be combined in an appropriate manner in any one or more embodiments or examples.

In addition, the above are only preferred embodiments of the present application and are not intended to limit the application. Any modifications, equivalent substitutions, and improvements made within the spirit and principles of the present application shall be included in the scope of protection of the present application.

The following embodiments are also disclosed:
1. An electrode structure of a back-contact solar cell, wherein the back-contact solar cell comprises a first polar region and a second polar region which are alternatively arranged, and the electrode structure includes:
   a plurality of first secondary gate electrodes and a plurality of second secondary gate electrodes, which are alternately spaced, wherein the first secondary gate electrode is used to collect the current in the first polar region, and the second secondary gate electrode is used to collect the current in the second polar region; and
   a plurality of first primary gate electrodes and a plurality of second primary gate electrodes, which are alternately spaced, wherein the first primary gate electrode is connected to the first secondary gate electrode and the second primary gate electrode is used to the second secondary gate electrode, the first and the second primary gate electrodes are arranged in a direction different from the first and the second secondary gate electrodes;
   the plurality of first secondary gate electrodes include a first collection gate electrode and a first connection gate electrode, the first collection gate electrode is connected to the first primary gate electrode and disconnected at the second primary gate electrode; the first connection gate electrode running through the second primary gate electrode connects the adjacent first primary gate electrodes, so that all the first primary gate electrodes are connected in parallel as an integral whole;
   a first spacing area is formed on the second primary gate electrode, and the first connection gate electrode passes through the first spacing area to connect two adjacent first primary gate electrodes, that is, the first connection gate electrode is insulated and isolated from the second primary gate electrode through the first spacing area.
2. The electrode structure of the back-contact solar cell according to embodiment 1, wherein a plurality of first connection gate electrodes are provided, and the first connection gate electrodes are spaced on the back-contact solar cell along the arrangement direction of the first and the second secondary gate electrodes.
3. The electrode structure of the back-contact solar cell according to embodiment 1, wherein the width of the first connection gate electrode is 80um-1.5mm; and/or the width of the first connection gate electrode is at least 1.5 times the wdith of the first connection gate electrode.
4. The electrode structure of the back-contact solar cell according to embodiment 1, wherein a plurality of first solder joints are spaced on the second primary gate electrode, and the position where the first connection gate electrode runs through the second primary gate electrode is located between two adjacent first solder joints.
5. The electrode structure of the back-contact solar cell according to embodiment 4, wherein the distance between the first connection gate electrode and the centerline between the two adjacent first solder joints is less than or equal to 10mm.
6. The electrode structure of the back-contact solar cell according to embodiment 5, wherein the distance between the first connection gate electrode and the centerline between the two adjacent first solder joints is less than or equal to 5mm.
7. The electrode structure of the back-contact solar cell according to embodiment 6, wherein the distance between the first connection gate electrode and the centerline between the two adjacent first solder joints is less than or equal to 3mm.
8. The electrode structure of the back-contact solar cell according to embodiment 7, wherein the distance between the first connection gate electrode and the centerline between the two adjacent first solder joints is less than or equal to 1mm.
9. The electrode structure of the back-contact solar cell according to embodiment 1, wherein the position where the first connection gate electrode runs through the second primary gate electrode is covered with a first insulation layer.
10. The electrode structure of the back-contact solar cell according to embodiment 1, wherein a plurality of second secondary gate electrodes include a second collection gate electrode and a second connection gate electrode, the second collection gate electrode is connected to the second primary gate electrode and disconnected at the first primary gate electrode, and the second connection gate electrode running through the first primary gate electrode between two adjacent second primary gate electrodes connects the two adjacent second primary gate electrodes.
11. The electrode structure of the back-contact solar cell according to embodiment 10, wherein a plurality of second connection gate electrodes are provided, and the second connection gate electrodes are spaced on the back-contact solar cell along the arrangement direction of the first and the second secondary gate electrodes.
12. The electrode structure of the back-contact solar cell according to embodiment 10, wherein the second connection gate electrodes are spaced adjacent to the first connection gate electrodes.
13. The electrode structure of the back-contact solar cell according to embodiment 12, wherein the second connection gate electrode and the first connection gate electrode evenly divide the back-contact solar cell into a plurality of identical areas in the arrangement direction of the first and the second secondary gate electrodes.
14. The electrode structure of the back-contact solar cell according to embodiment 10, wherein the width of the second connection gate electrode is 80um-1.5mm; and/or the width of the second connection gate electrode is at least 1.5 times the width of the second connection gate electrode.
15. The electrode structure of the back-contact solar cell according to embodiment 10, wherein a plurality of second solder joints are spaced on the first primary gate electrode, and the position where the second connection gate electrode runs through the first primary gate electrode is located between two adjacent second solder joints.
16. The electrode structure of the back-contact solar cell according to embodiment 15, wherein the distance between the second connection gate electrode and the centerline between the two adjacent second solder joints is less than or equal to 10mm.
17. The electrode structure of the back-contact solar cell according to embodiment 16, wherein the distance between the second connection gate electrode and the centerline between the two adjacent second solder joints is less than or equal to 5mm.
18. The electrode structure of the back-contact solar cell according to embodiment 17, wherein the distance between the second connection gate electrode and the centerline between the two adjacent second solder joints is less than or equal to 3mm.
19. The electrode structure of the back-contact solar cell according to embodiment 18, wherein the distance between the second connection gate electrode and the centerline between the two adjacent second solder joints is less than or equal to 1mm.
20. The electrode structure of the back-contact solar cell according to embodiment 10, wherein the position where the second connection gate electrode runs through the first primary gate electrode is covered with a second insulation layer.
21. A back-contact solar cell, including an electrode structure of the back-contact solar cell as claimed in any one of embodiments 1-20, wherein the electrode structure is disposed on the shady face of the back-contact solar cell.
22. A back-contact solar cell assembly, including the back-contact solar cell as claimed in embodiment 21.
23. A photovoltaic system, including a back-contact cell assembly as claimed in embodiment 22.

## Claims

1. An electrode structure of a back-contact solar cell, wherein the back-contact solar cell comprises a first polar region and a second polar region which are alternatively arranged, and the electrode structure includes:
a plurality of first secondary gate electrodes and a plurality of second secondary gate electrodes, which are alternately spaced, wherein the first secondary gate electrode is used to collect the current in the first polar region, and the second secondary gate electrode is used to collect the current in the second polar region; and
a plurality of first primary gate electrodes and a plurality of second primary gate electrodes, which are alternately spaced, wherein the first primary gate electrode is connected to the first secondary gate electrode and the second primary gate electrode is connected to the second secondary gate electrode, the first and the second primary gate electrodes are arranged in a direction different from the first and the second secondary gate electrodes;
the plurality of first secondary gate electrodes include a first collection gate electrode and a first connection gate electrode, the first collection gate electrode is connected to the first primary gate electrode and disconnected at the second primary gate electrode; the first connection gate electrode running through the second primary gate electrode connects the adjacent first primary gate electrodes, so that all the first primary gate electrodes are connected in parallel as an integral whole;
a first spacing area is formed on the second primary gate electrode, and the first connection gate electrode passes through the first spacing area to connect two adjacent first primary gate electrodes, that is, the first connection gate electrode is insulated and isolated from the second primary gate electrode through the first spacing area; and
wherein a plurality of first solder joints are spaced on the second primary gate electrode, and the position where the first connection gate electrode runs through the second primary gate electrode is located between two adjacent first solder joints, wherein the distance between the first connection gate electrode and the centerline between the two adjacent first solder joints is less than or equal to 10mm; or
wherein a plurality of second secondary gate electrodes include a second collection gate electrode and a second connection gate electrode, the second collection gate electrode is connected to the second primary gate electrode and disconnected at the first primary gate electrode, and the second connection gate electrode running through the first primary gate electrode between two adjacent second primary gate electrodes connects the two adjacent second primary gate electrodes, wherein a plurality of second solder joints are spaced on the first primary gate electrode, and the position where the second connection gate electrode runs through the first primary gate electrode is located between two adjacent second solder joints, wherein the distance between the second connection gate electrode and the centerline between the two adjacent second solder joints is less than or equal to 10mm.

2. The electrode structure of the back-contact solar cell according to claim 1, wherein a plurality of first connection gate electrodes are provided, and the first connection gate electrodes are spaced on the back-contact solar cell along the arrangement direction of the first and the second secondary gate electrodes.

3. The electrode structure of the back-contact solar cell according to claim 1, wherein the width of the first connection gate electrode is 80µm-1.5mm; and/or the width of the first connection gate electrode is at least 1.5 times the width of the first collection gate electrode.

4. The electrode structure of the back-contact solar cell according to claim 1, wherein the distance between the first connection gate electrode and the centerline between the two adjacent first solder joints is less than or equal to 5mm, preferably less than or equal to 3 mm, more preferably less than or equal to 1mm.

5. The electrode structure of the back-contact solar cell according to claim 1, wherein the position where the first connection gate electrode runs through the second primary gate electrode is covered with a first insulation layer.

6. The electrode structure of the back-contact solar cell according to claim 1, wherein a plurality of second connection gate electrodes are provided, and the second connection gate electrodes are spaced on the back-contact solar cell along the arrangement direction of the first and the second secondary gate electrodes.

7. The electrode structure of the back-contact solar cell according to claim 1, wherein the second connection gate electrodes are spaced adjacent to the first connection gate electrodes.

8. The electrode structure of the back-contact solar cell according to claim 7, wherein the second connection gate electrode and the first connection gate electrode evenly divide the back-contact solar cell into a plurality of identical areas in the arrangement direction of the first and the second secondary gate electrodes.

9. The electrode structure of the back-contact solar cell according to claim 1, wherein the width of the second connection gate electrode is 80µm-1.5mm; and/or the width of the second connection gate electrode is at least 1.5 times the width of the second collection gate electrode.

10. The electrode structure of the back-contact solar cell according to claim 1, wherein the distance between the second connection gate electrode and the centerline between the two adjacent second solder joints is less than or equal to 5mm, preferably less than or equal to 3 mm, more preferably less than or equal to 1 mm.

11. The electrode structure of the back-contact solar cell according to claim 1, wherein the position where the second connection gate electrode runs through the first primary gate electrode is covered with a second insulation layer.

12. A back-contact solar cell, including an electrode structure of the back-contact solar cell as claimed in any one of claims 1-11, wherein the electrode structure is disposed on the shady face of the back-contact solar cell.

13. A back-contact solar cell assembly, including the back-contact solar cell as claimed in claim 12.

14. A photovoltaic system, including a back-contact cell assembly as claimed in claim 13.
